# EUROPEAN PATENT SPECIFICATION

(11) **EP 3 677 658 B1**
(45) Date of publication and mention of the grant of the patent: **02.02.2022**
(21) Application number: 20150975.9
(22) Date of filing: 01.07.2016
(51) Int. Cl.: C09K 5/14, C08F 2/44, C08F 20/10, C08K 3/08, C08L 33/04, C08L 101/00, C09J 4/00, C09J 4/02, C09J 5/06, C09J 9/00, C09J 11/04, C09J 163/00, H01L 21/52, H01L 23/36, H01L 23/373, H01L 23/40, H01B 1/02, H01B 1/22

(54) **THERMALLY CONDUCTIVE COMPOSITION, SEMICONDUCTOR DEVICE, METHOD FOR MANUFACTURING SEMICONDUCTOR DEVICE, AND METHOD FOR BONDING HEATSINK**
WÄRMELEITFÄHIGE ZUSAMMENSETZUNG, HALBLEITERBAUELEMENT, VERFAHREN ZUR HERSTELLUNG EINES HALBLEITERBAUELEMENTS UND VERFAHREN ZUM BONDEN EINES KÜHLKÖRPERS
COMPOSITION THERMOCONDUCTRICE, DISPOSITIF SEMI-CONDUCTEUR, PROCÉDÉ DE FABRICATION DE DISPOSITIF SEMI-CONDUCTEUR ET PROCÉDÉ DE LIAISON DE DISSIPATEUR THERMIQUE

(30) Priority: 08.07.2015 JP 2015137152
(43) Date of publication of application: 08.07.2020
(62) Divisional of application: 16821323.9
(73) Proprietor: Sumitomo Bakelite Co.,Ltd., Tokyo 140-0002 (JP)
(72) Inventor: SHIMOBE, Yasuo, Tokyo, 140-0002 (JP); MURAYAMA, Ryuichi, Tokyo, 140-0002 (JP); SAITOH, Keiichiro, Tokyo, 140-0002 (JP)
(74) Representative: Müller-Boré & Partner Patentanwälte PartG mbB

(56) References cited:
- EP-A1- 2 717 304
- WO-A1-2014/038331

## Description

### TECHNICAL FIELD

The present invention relates to a thermally conductive composition, a semiconductor device, a method for manufacturing a semiconductor device, and a method for bonding a heatsink.

### BACKGROUND ART

As a resin composition for preparing an adhesive layer having thermal conductivity, for example, a paste containing metal particles is used in some cases. Examples of techniques relating to the paste include the technique described in Patent Document 1. Patent Document 1 describes a thermosetting resin composition containing (A) plate-type silver fine particles, (B) silver powder having a mean particle size of 0.5 to 30 µm, and (C) thermosetting resin.

Patent Document 1 describes that in a case where the plate-type silver fine particles are sintered, thermal conductivity can be improved further than in a case where filling is performed using only general silver powder. EP2717304A1 also describes thermally conductive compositions.

### RELATED DOCUMENT

### PATENT DOCUMENT

[Patent Document 1] Japanese Laid-open Patent Publication No. 2014-194013

### SUMMARY OF THE INVENTION

### TECHNICAL PROBLEM

According to the technique described in Patent Document 1, by using silver fine particles having a specific shape, the thermal conductivity of the resin composition can be improved. However, in a case where such plate-type silver particles are used, the uniformity at the time of causing sintering will not be assured.

It is considered that in a case where the uniformity at the time of causing sintering is not assured, the thermal conductivity of an adhesive layer will deteriorate.

The present invention has been made in consideration of the above circumstances, and an object thereof is to provide a thermally conductive composition having excellent sintering properties and high thermal conductivity.

### SOLUTION TO PROBLEM

According to the present invention, there is provided a thermally conductive composition according to claim 1.

According to the present invention, there is also provided a semiconductor device including a substrate and a semiconductor element mounted on the substrate through an adhesive layer obtained by performing a thermal treatment on the thermally conductive composition.

According to the present invention, there is also provided a method for manufacturing a semiconductor device, including a step of mounting a semiconductor element on a substrate through the thermally conductive composition, and a step of heating the thermally conductive composition.

According to the present invention, there is also provided a method for bonding a heatsink, including a step of bonding a heatsink to a semiconductor device through the thermally conductive composition, and a step of heating the thermally conductive composition.

### ADVANTAGEOUS EFFECTS OF INVENTION

According to the present invention, it is possible to provide a thermally conductive composition having excellent sintering properties and high thermal conductivity.

More specifically, in the thermally conductive composition of the present invention, the metal particles contained in the composition satisfy a specific D₅₀ value, and a standard deviation of a particles size of the metal particles is controlled and becomes equal to or less than a certain value. Accordingly, at the time of causing sintering, a uniform particle coupling structure can be formed. Furthermore, the formation of the uniform particle coupling structure can further improve the thermal conductivity.

The thermally conductive composition has characteristics of having excellent sintering properties and high thermal conductivity. Therefore, in a case where an adhesive layer is formed and a semiconductor device or the like is formed using the thermally conductive composition, the effect of improving heat release properties of the semiconductor device or the like is also obtained.

### BRIEF DESCRIPTION OF THE DRAWINGS

The aforementioned object, other objects, characteristics, and advantages are further clarified by suitable embodiments described below and the following drawings attached thereto.

FIG. 1 is a cross-sectional view showing a semiconductor device according to the present embodiment.
FIG. 2 is a cross-sectional view showing a modification example of the semiconductor device shown in FIG. 1.

### DESCRIPTION OF EMBODIMENTS

Hereinafter, embodiments or the present invention will be described using drawings as appropriate. In all the drawings, the same constituents are marked with the same reference signs, lest that the description thereof will be repeated.

In the present specification, unless otherwise specified, "to" means equal to or greater than the number listed before "to" and equal to or smaller than the number listed after "to".

### (Thermally conductive composition)

First the thermally conductive composition according to the present embodiment will be described. The thermally conductive composition according to the present embodiment is as below.

The thermally conductive composition contains metal particles (A) and a dispersion medium (B) in which the metal particles (A) are dispersed, wherein the metal particles (A) form a particle coupling structure by being sintered through a thermal treatment, the metal particles (A) have a particle size D₅₀ at 50% in a volume-based cumulative distribution of equal to or greater than 1 µm and equal to or smaller than 4 µm, and the metal particles (A) have a standard deviation of the particle size of equal to or less than 2.0 µm.

The thermally conductive composition according to the present embodiment is die-attach paste used for forming a die-attach layer (adhesive layer) for bonding a semiconductor element to other structures, for example. The aforementioned other structures are not particularly limited, and examples thereof include a substrate such as a wiring board or a lead frame, a semiconductor element, a heatsink, a magnetic shield, and the like. The thermally conductive composition can also be used for forming an adhesive layer for bonding a heatsink to other structures described above, for example.

It is preferable that the aforementioned other structures include a coat of silver or the like, which promotes the bonding, in a portion that the thermally conductive composition of the present embodiment contacts.

Hereinafter, each component constituting the thermally conductive composition of the present embodiment will be described.

### (Metal particles (A))

The metal particles (A) contained in the thermally conductive composition of the present embodiment form a particle coupling structure by causing sintering through a thermal treatment performed on the thermally conductive composition. That is, in an adhesive layer obtained by heating the thermally conductive composition, the metal particles (A) present in a state of being fused with each other.

In a case where the metal particles (A) are present in this state, it is possible to improve the thermal conductivity or the electric conductivity of the adhesive layer obtained by heating the thermally conductive composition and to improve the adhesiveness of the adhesive layer with respect to a substrate, a semiconductor element, a heatsink, or the like.

The shape of the metal particles (A) is not particularly limited, and examples of the shape include a spherical shape, a flake shape, a scale shape, and the like. In the present embodiment, the metal particles (A) more preferably contain spherical particles. In a case where the metal particles (A) contain spherical particles, the sintering properties of the metal particles (A) can be further improved, and the metal particles (A) can contribute to the improvement of the sintering uniformity.

Furthermore, from the viewpoint of reducing costs, it is possible to adopt an aspect in which the metal particles (A) contain flake-like particles. In addition, from the viewpoint of improving the balance between the cost reduction and the sintering uniformity, the metal particles (A) may contain both of the spherical particles and the flake-like particles.

In the present embodiment, for example, the total amount of the spherical particles and the flake-like particles contained in the metal particles (A) can be equal to or greater than 90% by mass and equal to or smaller than 100% by mass with respect to the total amount of the metal particles (A). The total amount of the spherical particles and the flake-like particles is more preferably equal to or greater than 95% by mass. In a case where the total amount of the spherical particles and the flake-like particles is as described above, the sintering uniformity can be more effectively improved. From the viewpoint of further improving the sintering uniformity, for example, the amount of spherical particles contained in the metal particles (A) with respect to the total amount of the metal particles (A) is more preferably equal to or greater than 90% by mass and equal to or smaller than 100% by mass, and even more preferably equal to or greater than 95% by mass.

The metal particles (A) contain one or two or more metals selected from the group consisting of silver (Ag), gold (Au), and copper (Cu), for example. In a case where the metal particles (A) contain the aforementioned metal, it is possible to improve the sintering properties of the metal particles (A) and to effectively improve the thermal conductivity and the electric conductivity of an adhesive layer obtained using the thermally conductive composition. For example, for the purpose of accelerating sintering or reducing costs, the metal particles (A) can contain a metal component other than Ag, Au, and Cu, in addition to the aforementioned materials.

The metal particles (A) can contain carbon, for example. The carbon contained in the metal particles (A) functions as a sintering aid when sintering occurs in the metal particles (A). Therefore, the carbon can improve the sintering properties of the metal particles (A). Herein, the state where the metal particles (A) contain carbon include a case where carbon is contained in the interior of the metal particles (A) or a case where carbon is physically or chemically adsorbed onto the surface of the metal particles (A).

As one of the examples of the case where the metal particles (A) contain carbon, an aspect is exemplified in which carbon-containing lubricant is attached to the metal particles (A) . Examples of such a lubricant include a higher fatty acid, a higher fatty acid metal salt, a higher fatty acid amide, and a higher fatty acid ester. The content of the lubricant with respect to the total amount of the metal particles (A) is preferably equal to or greater than 0.01% by mass and equal to or smaller than 5% by mass for example. In a case where the content of the lubricant is within the above range, it is possible to allow the carbon to effectively function as a sintering aid and to inhibit the reduction in the thermal conductivity.

In the present embodiment, a particle size D₅₀ of the metal particles (A) at 50% in a volume-based cumulative distribution is equal to or greater than 1 µm, and preferably equal to or greater than 1.2 µm. In a case where the particle size D₅₀ of the metal particles (A) at 50% in a volume-based cumulative distribution is equal to or greater than the aforementioned value, the thermal conductivity can be improved.

In contrast, the particle size D₅₀ of the metal particles (A) at 50% in a volume-based cumulative distribution is equal to or less than 4 µm. In a case where the particle size D₅₀ of the metal particles (A) at 50% in a volume-based cumulative distribution is equal to or less than the aforementioned value, the sintering properties between the metal particles (A) can be improved, and the sintering uniformity can be improved.

From the viewpoint of improving dispensing properties of the thermally conductive composition, the particle size D₅₀ of the metal particles (A) at 50% in a volume-based cumulative distribution is 1 µm and equal to or smaller than 3.5 µm, and particularly preferably equal to or greater than 0.6 µm and equal to or smaller than 3.0 µm.

The particle size of the metal particles (A) is determined by measuring particle images by using a flow-type particle image analyzer FPIA (registered trademark)-3000 manufactured by Sysmex Corporation. More specifically, by measuring a volume-based median diameter by using the aforementioned device, the particle size of the metal particles (A) can be determined. In the aforementioned method for measuring a particle size, the same condition can be adopted not only for D₅₀ but also for D₉₅ and D₅ shown below.

By adopting the aforementioned condition, for example, in a case where particles having a large particle size are present, the influence thereof can be sensitively detected. Furthermore, even the particles having a narrow particle size distribution such as the metal particles (A) of the present embodiment can be measured with high accuracy.

In the thermally conductive composition of the present embodiment, a standard deviation of the particle size of the metal particles (A) is set to be equal to or less than 2.0 µm. In a case where the standard deviation of the particle size of the metal particles (A) is set to be equal to or less than a specific value as above, the uniformity at the time of sintering can be further improved.

The standard deviation of the particle size of the metal particles (A) is preferably equal to or less than 1.9 µm, and more preferably equal to or less than 1.8 µm.

The lower limit of the standard deviation of the particle size of the metal particles (A) is not particularly limited, and is, for example, equal to or greater than 0.1 µm. Considering the ease of availability of the metal particles (A) used, the lower limit can be set to be equal to or greater than 0.3 µm.

Regarding D₅₀ and the standard deviation of the metal particles (A) contained in the thermally conductive composition of the present embodiment, a value obtained by dividing the aforementioned standard deviation of the particle size of the metal particles (A) by the particle size D₅₀ of the metal particles (A) at 50% in a volume-based cumulative distribution is preferably equal to or less than 2.5, preferably equal to or less than 2, and even more preferably equal to or less than 1.8.

In a case where the relationship between the standard deviation of the particle size and D₅₀ is set as described above, it is possible to further improve the sintering uniformity with eliminating the variation in the particle size of the entire metal particles (A).

The lower limit of the value obtained by dividing the standard deviation of the particle size of the metal particles (A) by the particle size D₅₀ of the metal particles (A) at 50% in a volume-based cumulative distribution is not particularly limited, and for example, equal to or greater than 0.1.

A particle size D₉₅ of the metal particles (A) at 95% in a volume-based cumulative distribution is preferably equal to or less than 10 µm, more preferably equal to or less than 9 µm, and even more preferably equal to or less than 8 µm.

In a case where the value of D₉₅ of the metal particles (A) is set as described above, it is possible to rule out excessively large metal particles (A) and to more effectively improve the balance between the sintering uniformity and the dispensing properties.

A particle size D₅ of the metal particles (A) at 5% in a volume-based cumulative distribution is preferably equal to or greater than 0.6 µm, more preferably equal to or greater than 0.7 µm, and even more preferably equal to or greater than 0.8 µm.

In a case where the value of D₅ of the metal particles (A) is set as described above, the thermal conductivity can be improved in a well-balanced manner.

In the present embodiment, in a case where a difference between D₉₅ and D₅₀ of the metal particles (A) is calculated, the value of D₉₅ - D₅₀ (difference between the particle size D₉₅ of the metal particles (A) at 95% in a volume-based cumulative distribution and the particle size D₅₀ of the metal particles (A) at 50% in a cumulative distribution based on volume) is preferably equal to or less than 5 µm, more preferably equal to or less than 4 µm, and even more preferably equal to or less than 3.5 µm.

In a case where the difference between D₉₅ and D₅₀ of the metal particles (A) is set to be the aforementioned value, the variation in the particle size of the metal particles (A) can be suppressed, and the sintering uniformity and the dispensing properties can be more effectively improved in a well-balanced manner.

The content of the metal particles (A) in the thermally conductive composition is, with respect to the total amount of the thermally conductive composition, preferably equal to or greater than 80% by mass, and more preferably equal to or greater than 85% by mass, for example. In a case where the content of the metal particles (A) is as described above, the sintering properties of the metal particles (A) can be improved, and the metal particles (A) can contribute to the improvement of the thermal conductivity and the electric conductivity.

In contrast, the content of the metal particles (A) in the thermally conductive composition is, with respect to the total amount of the thermally conductive composition, preferably equal to or less than 95% by mass, and particularly preferably equal to or less than 90% by mass, for example. In a case where the content of the metal particles (A) is as described above, the metal particles (A) can contribute to the improvement of the overall coating workability of the thermally conductive composition, the mechanical strength of the adhesive layer, and the like.

In the present specification, in a case where the thermally conductive composition contains a solvent (S), the content with respect to the total amount of the thermally conductive composition refers to a content with respect to all the components of the thermally conductive composition excluding the solvent.

### (Dispersion medium (B))

The thermally conductive resin composition of the present embodiment contains a dispersion medium in which the metal particles (A) are dispersed.

As the dispersion medium (B), known materials may be adopted among materials in which the metal particles (A) can be dispersed, as long as the dispersion medium includes both, a compound having only one radically polymerizable double bond in a molecule and a compound having two or more epoxy groups in a molecule. However, the thermally conductive resin composition of the present embodiment is a material which is preferably used for preparing an adhesive layer by being cured, and accordingly, it is preferable to use a compound polymerized by heating as the dispersion medium (B) .

The compound polymerized by heating can contain one or two or more compounds selected from a compound (B1) having only one radically polymerizable double bond in a molecule and a compound (B2) having only one epoxy group in a molecule, for example. In a case where the compound polymerized by heating contains the aforementioned compound, when the thermally conductive composition is thermally treated, the compound (B) can be linearly polymerized. Therefore, the balance between the sintering uniformity and the dispensing properties can be improved.

Examples of the compound (B1) having only one radically polymerizable double bond in a molecule include an ester of a (meth)acryl group having only one (meth)acryl group in a molecule. By using the ester having a (meth)acryl group, the sintering uniformity can be more effectively improved.

In the present embodiment, the (meth)acrylic acid ester contained in the compound (B1) having only one radically polymerizable double bond in a molecule can contain one or two or more compounds selected from compounds represented by Formula (1), for example. In a case where the (meth) acrylic acid ester contains such compounds, the sintering uniformity can be more effectively improved.

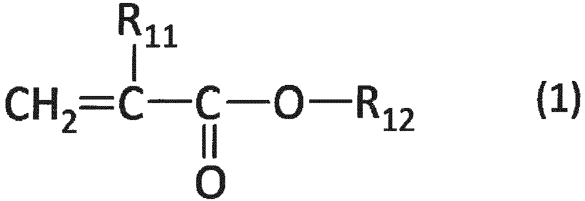

In Formula (1), R₁₁ represents hydrogen or a methyl group, and R₁₂ represents a monovalent organic group having 1 to 20 carbon atoms. R₁₂ may contain one atom or two or more atoms selected from an oxygen atom, a nitrogen atom, and a phosphorus atom. The structure of R12 may contain a -OH group such as a hydroxyl group or a carboxyl group, a glycidyl group, an oxetanyl group, an amino group, an amide group, and the like.

The compound represented by Formula (1) is not particularly limited. However, as the compound in which the structure of R₁₂ contains a -OH group, it is possible to use one or two or more compounds selected from 1,4-cyclohexanedimethanol monoacrylate, 2-hydroxyethyl acrylate, 2-hydroxyethyl methacrylate, 2-hydroxypropyl acrylate, 2-hydroxypropyl methacrylate, 2-hydroxybutyl acrylate, 2-hydroxybutyl methacrylate, 2-hydroxy-3-phenoxypropyl acrylate, 2-acryloyloxyethyl succinate, 2-methacryloyloxyethyl succinate, 2-acryloyloxyethyl hexahydrophthalate, 2-methacryloyloxyethyl hexahydroxyphthalate, 2-acryloyloxyethyl phthalate, 2-acryloyloxyethyl-2-hydroxyethyl phthalate, 2-acryloyloxyethyl acid phosphate, and 2-methacryloyloxyethyl acid phosphate.

In the present embodiment, as one of the examples of preferred aspects, it is possible to adopt a case where the (meth) acrylic acid ester contains a compound containing a cyclic structure in R₁₂ as illustrated in 1,4-cyclohexanedimethanol monoacrylate or a compound containing a carboxyl group in R₁₂ as illustrated in 2-methacryloyloxyethyl succinate.

It is possible for R₁₂ in Formula (1) not to contain a -OH group. As such a compound, for example, it is possible to use one compound or two or more compounds selected from ethyl methacrylate, n-butyl methacrylate, isobutyl methacrylate, tert-butyl methacrylate, isoamyl acrylate, 2-ethylhexyl methacrylate, isodecyl methacrylate, n-lauryl acrylate, n-lauryl methacrylate, n-tridecyl methacrylate, n-stearyl acrylate, n-stearyl methacrylate, isostearyl acrylate, ethoxydiethylene glycol acrylate, butoxydiethylene glycol methacrylate, methoxytriethylene glycol acrylate, 2-ethylhexyl diethylene glycol acrylate, methoxypolyethylene glycol acrylate, methoxypolyethylene glycol methacrylate, methoxydipropylene glycol acrylate, cyclohexyl methacrylate, tetrahydrofurfuryl acrylate, tetrahydrofurfuryl methacrylate, benzyl methacrylate, phenoxyethyl acrylate, phenoxyethyl methacrylate, phenoxydiethylene glycol acrylate, phenoxypolyethylene glycol acrylate, nonyl phenol ethylene oxide-modified acrylate, phenyl phenol ethylene oxide-modified acrylate, isobornyl acrylate, isobornyl methacrylate, dimethylaminoethyl methacrylate, diethylaminoethyl methacrylate, quaternized dimethylaminoethyl methacrylate, glycidyl methacrylate, and neopentyl glycol acrylate benzoic acid ester.

In the present embodiment, as one of the examples of preferred aspects, it is possible to adopt a case where the (meth) acrylic acid ester contains a compound containing a cyclic structure in R₁₂ as illustrated in phenoxyethyl methacrylate and cyclohexyl methacrylate or a compound in which R₁₂ is a linear or branched alkyl group as illustrated in 2-ethylhexyl methacrylate, n-lauryl acrylate, and n-lauryl methacrylate.

In the present embodiment, from the viewpoint of improving balance between various properties such as the sintering uniformity and the mechanical strength, it is possible to adopt an aspect in which the (meth)acrylic acid ester contained in the compound (B1) having only one radically polymerizable double bond in a molecule contains both of the compound in which R₁₂ contains a -OH group and the compound in which R₁₂ does not contain a -OH group among the compounds represented by Formula (1), for example.

In contrast, the compound (B1) may contain only any one of the compounds in which R₁₂ contains a -OH group and the compound in which R₁₂ does not contain a -OH group among the compounds represented by Formula (1).

The compound (B2) having only one epoxy group in a molecule can contain one compound or two or more compounds selected from n-butylglycidyl ether, a versatic acid glycidyl ester, styrene oxide, ethyl hexyl glycidyl ether, phenyl glycidyl ether, butyl phenyl glycidyl ether, and cresyl glycidyl ether, for example. From the viewpoint of improving the balance among the sintering uniformity, the thermal conductivity, the electric conductivity, and the like, as one of the examples of preferred aspect, it is possible to adopt a case where the compound (B2) contains at least cresyl glycidyl ether among the above compounds.

In a case where the compound (B) contains both of the compound (B2) and the compound (B3) having two or more epoxy groups in a molecule. , from the viewpoint of improving the balance between the sintering uniformity and the dispensing properties, as one of the examples of preferred aspects, it is possible to adopt a case where the content of the compound (B3) with respect to the total amount of the dispersion medium (B) is greater than 0.01% by mass and equal to or less than 60% by mass.

As one of the examples of aspect, the dispersion medium (B) does not contain a compound having two or more radically polymerizable double bonds in a molecule . In a case where the dispersion medium (B) does not contain the above compound, the compound (B) can be linearly polymerized and can contribute to the improvement of the sintering uniformity.

In contrast, the dispersion medium (B) may contain a compound having two or more radically polymerizable double bonds in a molecule or a compound having two or more epoxy groups in a molecule. In a case where the compound (B) contains the compound having two or more radically polymerizable double bonds in a molecule or the compound having two or more epoxy groups in a molecule, the total content of the aforementioned compounds is preferably set to be greater than 0% by mass and equal to or less than 5% by mass with respect to the total amount of the dispersion medium (B). In a case where total content of the aforementioned compound is within the above range, it is possible to inhibit many three-dimensional cross-linked structures from being incorporated into the polymerized structure generated by the dispersion medium (B). As a result, it is possible to smoothly perform the sintering of the metal particles (A).

The content of the dispersion medium (B) contained in the thermally conductive composition is, with respect to the total amount of the thermally conductive composition, preferably equal to or greater than 3% by mass, more preferably equal to or greater than 5% by mass, and even more preferably equal to or greater than 8% by mass, for example. In a case where the content of the compound (B) is as described above, it is possible to more effectively improve the sintering uniformity, and the dispersion medium (B) can contribute to the improvement of the mechanical strength of the adhesive layer obtained from the thermally conductive composition and the like. In contrast, the content of the dispersion medium (B) contained in the thermally conductive composition is, with respect to the total amount of the thermally conductive composition, preferably equal to or less than 20% by mass, more preferably equal to or less than 18% by mass, and even more preferably equal to or less than 15% by mass, for example. In a case where the content of the compound (B) is as described above, the compound (B) can contribute to the improvement of the sintering properties of the metal particles (A) .

### (Curing agent (C))

The thermally conductive composition of the present embodiment can contain a curing agent (C), for example. As the curing agent (C), the compounds accelerating the polymerization reaction of the dispersion medium (B) described above can be used. In a case where such compounds are used, the mechanical properties of an adhesive layer obtained using the thermally conductive composition can be improved.

In the present embodiment, from the viewpoint of improving the balance among the sintering uniformity, the thermal conductivity, the electric conductivity, and the like, it is possible to adopt an aspect in which the thermally conductive composition does not contain the curing agent (C). The aspect in which the thermally conductive composition does not contain the curing agent (C) refers to a case where the content of the curing agent (C) with respect to 100 parts by mass of the dispersion medium (B) is equal to or less than 0.01 parts by mass, for example.

The curing agent (C) can contain a compound having a tertiary amino group, for example. If the curing agent (C) contains such a compound, for example, in a case where the dispersion medium (B) contains a compound having an epoxy group in a molecule, it is possible to accelerate the polymerization of the compound having an epoxy group in a molecule. Examples of the compound having a tertiary amino group include tertiary amines such as benzyldimethylamine (BDMA), imidazoles such as 2-methylimidazole and 2-ethyl-4-methylimidazole (EMI 24); pyrazoles such as pyrazole, 3,5-dimethylpyrazole, and pyrazoline; triazoles such as triazole, 1,2,3-triazole, 1,2,4-triazole, and 1,2,3-benzotriazole; and imidazolines such as imidazoline, 2-methyl-2-imidazoline, and 2-phenylimidazoline. The curing agent (C) can contain one or two or more compounds selected from these. If the curing agent (C) contains the above compound, for example, in a case where the dispersion medium (B) contains a compound having an epoxy group in a molecule, the ring-opening homopolymerization of the epoxy group can be selectively accelerated. From the viewpoint of improving the balance among the sintering uniformity, the thermal conductivity, and the electric conductivity, as one of the examples of preferred aspects, it is possible to adopt an aspect in which the curing agent (C) contains at least imidazoles among the above compounds.

The curing agent (C) can contain a radical polymerization initiator, for example. If the curing agent (C) contains a radical polymerization initiator, for example, in a case where the dispersion medium (B) contains a compound having a radically polymerizable double bond in a molecule, it is possible to accelerate the polymerization of the compound having a radically polymerizable double bond in a molecule. The curing agent (C) can contain, as the radical polymerization initiator, one or two or more compounds selected from octanoyl peroxide, lauroyl peroxide, stearoyl peroxide, 1,1,3,3-tetramethylbutyl peroxy 2-ethyl hexanoate, oxalic acid peroxide, 2,5-dimethyl-2,5-di(2-ethylhexanoylperoxy)hexane, 1-cyclohexyl-1-methylethylperoxy 2-ethylhexanoate, t-hexylperoxy 2-ethylhexanoate, t-butylperoxy 2-ethylhexanoate, m-toluyl peroxide, benzoyl peroxide, methyl ethyl ketone peroxide, acetyl peroxide, t-butyl hydroperoxide, di-t-butyl peroxide, cumen hydroperoxide, dicumyl peroxide, t-butyl perbenzoate, parachlorobenzoyl peroxide, and cyclohexanone peroxide.

The content of the curing agent (C) contained in the thermally conductive composition can be set to be equal to or less than 25 parts by mass with respect to 100 parts by mass of the dispersion medium (B), for example. Particularly, in a case where the thermally conductive composition contains the compound (B1) having only one radically polymerizable double bond in a molecule as the dispersion medium (B), from the viewpoint of improving the sintering uniformity, the content of the curing agent (C) with respect to 100 parts by mass of the dispersion medium (B) is preferably set to be equal to or less than 5 parts by mass, more preferably set to be equal to or less than 3 parts by mass, and particularly preferably set to be equal to or less than 1 part by mass.

Furthermore, the content of the curing agent (C) contained in the thermosetting composition can be set to be equal to or greater than 0 part by mass with respect to 100 parts by mass of the dispersion medium (B). From the viewpoint of improving the mechanical properties of the thermally conductive composition, the content of the curing agent (C) with respect to 100 parts by mass of the dispersion medium (B) can be set to be equal to or greater than 0.1 parts by mass, for example.

### (Polymerization inhibitor (D))

The thermally conductive composition can contain a polymerization inhibitor (D), for example. As the polymerization inhibitor (D), a compound inhibiting the polymerization reaction of the compounds contained in the thermally conductive composition is used. In a case where the thermally conductive composition contains the polymerization inhibitor (D), the storage properties of the thermally conductive composition can be further improved. The Polymerization inhibitor (D) is not particularly limited. For example, the thermally conductive composition can contain, as the polymerization inhibitor (D), one or two or more compounds selected from hydroquinones such as hydroquinone, p-tert-butylcatechol, and mono-tert-butyl hydroquinone; phenols such as hydroquinone monomethyl ether and di-p-cresol; quinones such as p-benzoquinone, naphthoquinone, and p-toluquinone; and a copper salt such as copper naphthenate.

The content of the polymerization inhibitor (D) in the thermally conductive composition is, with respect to 100 parts by mass of the dispersion medium (B), preferably equal to or greater than 0.0001 parts by mass, and more preferably equal to or greater than 0.001 parts by mass, for example. In a case where the content of the polymerization inhibitor (D) is as described above, the polymerization inhibitor (D) can contribute to the improvement of the sintering uniformity, and the storage properties of the thermally conductive composition can be more effectively improved.

In contrast, the content of the polymerization inhibitor (D) in the thermally conductive composition is, with respect to 100 parts by mass of the dispersion medium (B), preferably set to be equal to or less than 0.5 parts by mass, and more preferably set to be equal to or less than 0.1 parts by mass, for example. In a case where the content of the polymerization inhibitor (D) is as described above, the mechanical strength of the adhesive layer and the like can be improved.

The thermally conductive composition according to the present embodiment can contain a solvent (S), for example. In a case where the thermally conductive composition contains the solvent (S), the fluidity of the thermally conductive composition is improved, and hence the solvent (S) can contribute to the improvement of workability. In the present embodiment, the solvent (S) refers to a substance that does not correspond to the dispersion medium (B) described above.

The solvent (S) is not particularly limited. The thermally conductive composition can contain, as the solvent (S), one or two or more solvents selected from alcohols such as ethyl alcohol, propyl alcohol, butyl alcohol, pentyl alcohol, hexyl alcohol, heptyl alcohol, octyl alcohol, nonyl alcohol, decyl alcohol, ethylene glycol monomethyl ether, ethylene glycol monoethyl ether, ethylene glycol monopropyl ether, ethylene glycol monobutyl ether, propylene glycol monomethyl ether, propylene glycol monoethyl ether, propylene glycol monopropyl ether, propylene glycol monobutyl ether, methyl methoxybutanol, α-terpineol, β-terpineol, hexylene glycol, benzyl alcohol, 2-phenylethyl alcohol, isopalmityl alcohol, isostearyl alcohol, lauryl alcohol, ethylene glycol, propylene glycol, and glycerin; ketones such as acetone, methyl ethyl ketone, methyl isobutyl ketone, cyclohexanone, diacetone alcohol (4-hydroxy-4-methyl-2-pentanone), 2-octanone, isophorone (3,5,5-trimethyl-2-cyclohexen-1-one), and diisobutyl ketone (2,6-dimethyl-4-heptanone); esters such as ethyl acetate, butyl acetate, diethyl phthalate, dibutyl phthalate, acetoxyethane, methyl butyrate, methyl hexanoate, methyl octanoate, methyl decanoate, methyl cellosolve acetate, ethylene glycol monobutyl ether acetate, propylene glycol monomethyl ether acetate, 1,2-diacetoxyethane, tributyl phosphate, tricresyl phosphate, and tripentyl phosphate; ethers such as tetrahydrofuran, dipropyl ether, ethylene glycol dimethyl ether, ethylene glycol diethyl ether, ethylene glycol dibutyl ether, propylene glycol dimethyl ether, ethoxyethyl ether, 1,2-bis(2-diethoxy)ethane, and 1,2-bis(2-methoxyethoxy)ethane; ester ethers such as 2-(2-butoxyethoxy)ethane acetate; ether alcohols such as 2-(2-methoxyethoxy)ethanol; hydrocarbons such as toluene, xylene, n-paraffin, isoparaffin, dodecylbenzene, turpentine oil, kerosene, and diesel oil; nitriles such as acetonitrile and propionitrile; amides such as acetamide and N,N-dimethylformamide; silicon oil such as low-molecular weight volatile silicon oil and organically modified volatile silicon oil.

Next, the characteristics of the thermally conductive composition of the present embodiment will be described.

In a case where dynamic viscoelasticity of the thermally conductive composition according to the present embodiment is measured under a condition of a measurement frequency of 1 Hz, within a temperature region of 140°C to 180°C, the composition preferably has a temperature width W of equal to or larger than 10°C in which a shear modulus of elasticity is equal to or higher than 5,000 Pa and equal to or lower than 100, 000 Pa. If a case where the thermally conductive composition has such a temperature width, in a case where an adhesive layer is formed, it is possible to improve the sintering uniformity of the metal particles (A) in a central portion and a peripheral portion of in a surface direction.

Particularly, in a case where the thermally conductive composition is used and sintering of the metal particles (A) is caused to proceed through a thermal treatment under a low-temperature condition of lower than 200°C as will be described later, the sintering of the metal particles (A) can more uniformly proceed in the central portion and the peripheral portion of the adhesive layer in the surface direction.

In a case where the sintering of the metal particles (A) contained in the thermally conductive composition is performed under a high-temperature condition, there is apprehension that the extent of proceeding of sintering will vary between the central portion and the peripheral portion of the adhesive layer. However, hitherto, in some cases, it has been difficult for the sintering of the metal particles to uniformly and sufficiently proceed by a thermal treatment performed under a low-temperature condition. It is considered that this is because the sintering of the metal particles is hindered by other components contained in the thermally conductive composition with the thermal treatment performed under a low-temperature condition.

In contrast, in a case where the thermally conductive composition satisfies the aforementioned condition relating to the shear modulus of elasticity, when the sintering proceeds, it is easy for the metal particles (A) to push aside other components and contact each other. Therefore, even in a case where the sintering of the metal particles (A) is allowed to proceed by a thermal treatment performed a low-temperature condition of lower than 200°C for example, the sintering of the metal particles (A) is not hindered, and it is possible to obtain a certain temperature region in which the viscoelasticity of the thermally conductive composition is adjusted such that the uniform dispersibility of the metal particles (A) can be maintained. It is considered that for this reason, although this is not an undoubted reason, the sintering of the metal particles (A) can uniformly proceed in the central portion and the peripheral portion of the adhesive layer in the surface direction.

In the present embodiment, from the viewpoint of improving the sintering uniformity, the temperature width W is more preferably equal to or larger than 15°C, even more preferably equal to or larger than 20°C, and particularly preferably equal to or larger than 25°C. The upper limit of the temperature width W is not particularly limited, and can be set to be equal to or smaller than 40°C. From the viewpoint of the productivity of a semiconductor device, the upper limit of the temperature width W is more preferably equal to or smaller than 35°C.

By controlling the upper limit and the lower limit of the temperature width as described above, it is possible to more suitably form a coupling structure of conductive metal particles having high thermal conductivity.

In the present embodiment, the dynamic viscoelasticity of the thermally conductive composition can be measured using, for example, a rheometer (HAAKE RheoWin, manufactured by Thermo Fisher Scientific) under conditions of a measurement frequency of 1 Hz, a heating rate of 5°C/min, and a range of measurement temperature of 25°C to 250°C.

The viscoelastic behavior of the thermally conductive composition having the aforementioned temperature width W can be controlled by adjusting the type or the formulation ratio of components contained in the thermally conductive composition, for example. In the present embodiment, the type or the formulation ratio of the dispersion medium (B) is particularly important. Furthermore, it is considered that in addition to the metal particles (A) or the dispersion medium (B), for example, the adjustment of the type or the formulation ratio of a curing agent (C) or the like can be a factor affecting the temperature width W. Presumably, in order to control the temperature width W within an intended range, it is extremely important to appropriately select the type or the formulation ratio of each of the above components such that a thermally conductive composition is constituted in which the dispersion medium (B) can be appropriately linearly polymerized when being subjected to a thermal treatment.

In the thermally conductive composition according to the present embodiment, an acetone insoluble fraction of a sample, which is obtained by removing the metal particles (A) and then heating the composition under conditions of 180°C and 2 hours, is equal to or lower than 5% by mass. In a case where the acetone insoluble fraction is set as described above, it is possible to further improve the sintering uniformity of the metal particles (A) in the central portion and the peripheral portion of the adhesive layer in the surface direction. Presumably, the thermally conductive composition in which the acetone insoluble fraction after heating is equal to or lower than 5% by mass can be obtained by adopting an aspect in which the dispersion medium (B) undergoes not three-dimensional cross-linking but a linear polymerization reaction. In this case, it is possible to inhibit the sintering of the metal particles (A) from being hindered due to a resin. It is considered that for this reason, although this is not an undoubted reason, the sintering uniformity of the metal particles (A) may be improved.

In the present embodiment, the aforementioned acetone insoluble fraction can be measured as below, for example. First, by centrifugation and filtration using a 115 mesh filter (125 µm opening), the metal particles (A) are removed from the thermally conductive composition. Then, the thermally conductive composition from which the metal particles (A) have been removed is heated under conditions of 180°C and 2 hours, thereby obtaining a measurement sample. Thereafter, approximately 100 g of the measurement sample was weighed and put into an airtight container containing approximately 900 g of acetone with a liquid temperature of 25°C, and then shaken for about 20 minutes. The acetone solution obtained in this way and an acetone solution obtained by washing off the inside of the airtight container with approximately 100 g of acetone are passed through a 115 mesh (125 µm opening) JIS standard sieve. Consequently, approximately 100 g of acetone is passed through the entirety of the sieve. Then, the residue on the sieve is air-dried, and then the weight of the residue is measured. From the measured result, a ratio (% by mass) of the residue to the measurement sample is calculated and taken as an acetone insoluble fraction (% by mass).

The amount of the acetone insoluble fraction of the thermally conductive composition can be controlled by adjusting the type or the formulation ratio of the components contained in the thermally conductive composition, for example. In the present embodiment, the type or the formulation ratio of the dispersion medium (B) is particularly important. Furthermore, it is considered that in addition to the metal particles (A) or the dispersion medium (B), for example, the adjustment of the type or the formulation ratio of the curing agent (C) can be a factor affecting the acetone insoluble fraction. Presumably, in order to control the acetone insoluble fraction within an intended range, it is extremely important to appropriately select the type or the formulation ratio of each of the above components such that a thermosetting composition is constituted in which the dispersion medium (B) is appropriately cured, for example.

For example, in a case where the thermally conductive composition according to the present embodiment is formed into a coating film by coating, and a film is obtained by heating the obtained coating film to 250°C from 25°C at a heating rate of 5°C/min and then heating the coating film under conditions of 250°C and 2 hours, a thermal conductivity of the film in a thickness direction is preferably equal to or higher than 15 W/mK. In a case where the thermal conductivity is as described above, it is possible to improve the thermal conductivity of an adhesive layer obtained using the thermally conductive composition. Therefore, the adhesive layer can contribute to the improvement of the heat release properties of an electronic part constituted with the adhesive layer. In the present embodiment, the thermal conductivity in the thickness direction is more preferably equal to or higher than 30 W/mK, even more preferably equal to or higher than 40 W/mK, and particularly preferably equal to or higher than 50 W/mK.

The upper limit of the thermal conductivity in the thickness direction is not particularly limited, and can be set to be equal to or lower than 200 W/mK, for example. The thermal conductivity in the thickness direction can be controlled by adjusting the type or the formulation ratio of components contained in thermally conductive composition, for example.

For example, in a case where the thermally conductive composition according to the present embodiment is formed into a coating film by coating, and a film is obtained by heating the obtained coating film to 250°C from 25°C at a heating rate of 5°C/min and then heating the coating film under conditions of 250°C and 2 hours, a volume resistivity of the film in a surface direction is preferably equal to or lower than 25 × 10⁻⁶ Ω·cm. In a case where the volume resistivity is as described above, the electric conductivity of an adhesive layer obtained using the thermally conductive composition can be improved. In the present embodiment, the volume resistivity in the surface direction is more preferably equal to or lower than 15 × 10⁻⁶ Ω·cm, and even more preferably equal to or lower than 8 × 10⁻⁶ Ω·cm. The volume resistivity in the surface direction can be controlled by adjusting the type or the formulation ratio of components contained in the thermally conductive composition, for example.

A temperature at 5% weight loss of the thermally conductive composition according to the present embodiment is preferably equal to or higher than 100°C and equal to or lower than 180°C. In a case where the temperature at 5% weight loss is as described above, the sintering of the metal particles (A) can be further accelerated. Therefore, the thermal conductivity or the electric conductivity of an adhesive layer obtained using the thermally conductive composition can be further improved.

In the present embodiment, from the viewpoint of improving the balance between temporal stability and sintering properties, the temperature at 5% weight loss is preferably equal to or higher than 100°C and equal to or lower than 160°C. The temperature at 5% weight loss can be controlled by adjusting the type or the formulation ratio of components contained in the thermally conductive composition, for example.

In the present embodiment, for example, by performing thermogravimetry/differential thermal analysis (TG/DTA) on 10 mg of the thermally conductive composition in a nitrogen atmosphere or an air atmosphere under a condition of a heating rate of 5°C/min, the temperature at 5% weight loss of the thermally conductive composition can be measured.

### (Semiconductor device)

Next, an example of the semiconductor device according to the present embodiment will be described.

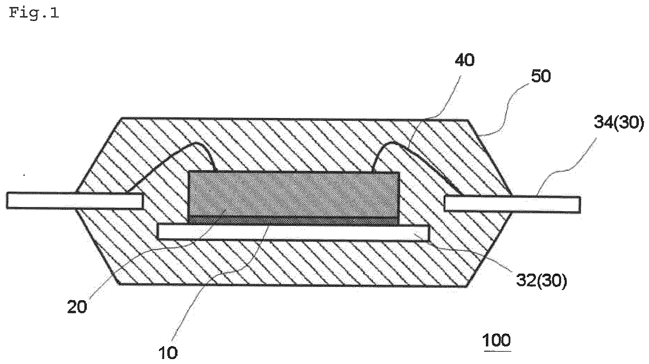

FIG. 1 is a cross-sectional view showing a semiconductor device 100 according to the present embodiment. The semiconductor device 100 according to the present embodiment includes a substrate 30, and a semiconductor element 20 mounted on the substrate 30 through an adhesive layer (die-attach layer 10) which is obtained by thermally treating the thermally conductive composition. The semiconductor element 20 and the substrate 30 are electrically connected to each other through a bonding wire 40, for example. The semiconductor element 20 is sealed with a sealing resin 50, for example. The film thickness of the die-attach layer 10 is not particularly limited, but is equal to or greater than 5 µm and equal to or smaller than 100 µm, for example.

In the example shown in FIG. 1, the substrate 30 is a lead frame, for example. In this case, the semiconductor element 20 is mounted on a die pad 32 (30) through the die-attach layer 10. The semiconductor element 20 is electrically connected to an outer lead 34 (30) through the bonding wire 40, for example. The substrate 30 as a lead frame is constituted with a 42 alloy or a Cu frame, for example. The substrate 30 may be an organic substrate or a ceramic substrate. As the organic substrate, for example, the substrates obtained using an epoxy resin, a cyanate resin, a maleimide resin, and the like that are known to those in the related art are suitable. Furthermore, the surface of the substrate 30 may be coated with silver or the like such that the adhesiveness of the thermally conductive composition with respect to the substrate is improved.

The planar shape of the semiconductor element 20 is not particularly limited, but is a rectangular shape, for example. In the present embodiment, for example, it is possible to adopt a rectangular semiconductor element 20 having a chip size of equal to or greater than 0.5 mm and equal to or smaller than 15 mm on one side.

One of the examples of the semiconductor device 100 according to the present embodiment is a semiconductor device in which a large rectangular chip having a length of, for example, equal to or greater than 5 mm on one side is used as the semiconductor element 20. In this case, because the area of a die-attach layer also increases, there is apprehension that it will be difficult to uniformly sinter metal particles in the central portion and the peripheral portion of the die-attach layer. According to the present embodiment, even in a case where such a large chip is used, the sintering uniformity of the metal particles in the central portion and the peripheral portion of the die-attach layer can be greatly improved.

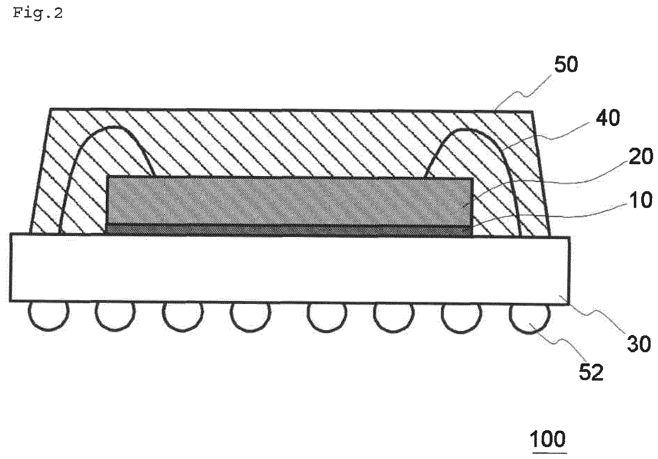

FIG. 2 is a cross-sectional view showing a modification example of the semiconductor device 100 shown in FIG. 1.

In the semiconductor device 100 according to the present modification example, the substrate 30 is an interposer, for example. In the substrate 30 as an interposer, on a surface opposite to the surface on which the semiconductor element 20 is mounted, for example, a plurality of solder balls 52 are formed. In this case, the semiconductor device 100 is connected to other wiring boards through the solder balls 52.

The semiconductor device 100 according to the present embodiment can be manufactured as below, for example. First, through the aforementioned thermally conductive composition, the semiconductor element 20 is mounted on the substrate 30. Then, the thermally conductive composition is heated. In this way, the semiconductor device 100 is manufactured.

Hereinafter, the method for manufacturing the semiconductor device 100 will be specifically described.

First, through the aforementioned thermally conductive composition, the semiconductor element 20 is mounted on the substrate 30. In the present embodiment, for example, the substrate 30 is coated with the thermally conductive composition, and then the semiconductor element 20 is mounted on the coating film formed of the thermally conductive composition. The coating method of the thermally conductive composition is not particularly limited, and examples thereof include dispensing, a printing method, and an ink jet method.

Thereafter, the thermally conductive composition is subjected to a thermal treatment. At this time, sintering occurs in the metal particles (A) in the thermally conductive composition, and hence a particle coupling structure is formed between the metal particles (A). As a result, the die-attach layer 10 is formed on the substrate 30. In the present embodiment, for example, it is possible to perform the thermal treatment in a state of applying a pressure to the thermally conductive composition.

In the present embodiment, for example, it is possible to perform a step (hereinafter, referred to as a first thermal treatment as well) of heating the thermally conductive composition under a temperature condition of lower than 200°C and then perform a step (hereinafter, referred to as a second thermal treatment as well) of heating the thermally conductive composition under a temperature condition of equal to or higher than 200°C. In this way, by heating the thermally conductive composition according to the present embodiment under a low-temperature condition of lower than 200°C in the first thermal treatment, it is possible to more reliably inhibit the proceeding of sintering of the metal particles (A) from being hindered due to the dispersion medium (B) or the like. Accordingly, in both of the peripheral portion and the central portion of the die-attach layer, the metal particles (A) can be more uniformly and sufficiently sintered.

For example, in the manufacturing method according to the present embodiment, by heating the composition for a certain period of time under a temperature condition of a temperature T₁ lower than 200°C and then heating the composition for a certain period of time under a temperature condition of a temperature of T₂ equal to or higher than 200°C, the first thermal treatment and the second thermal treatment can be performed. T₁ can be set to be equal to or higher than 120°C and lower than 200°C, for example. T₂ can be set to be equal to or higher than 200°C and equal to or lower than 350°C, for example. In the present example, the treatment time of the first thermal treatment performed at the temperature T₁ can be set to be equal to or longer than 20 minutes and equal to or shorter than 90 minutes, for example. Furthermore, the treatment time of the second thermal treatment performed at the temperature T₂ can be set to be equal to or longer than 30 minutes and equal to or shorter than 180 minutes, for example.

Meanwhile, in the present embodiment, by heating the composition to a temperature T₃ which is equal to or higher than 200°C from 25°C without ceasing and then heating the composition for a certain period of time under a temperature condition of the temperature T₃, the thermal treatment may be performed on the thermally conductive composition. In this case, a period of time during which the temperature does not yet reach 200°C in the step of heating can be regarded as the first thermal treatment, and a step of heating the composition to the temperature T₃ from 200°C and performing a thermal treatment at the temperature T₃ can be regarded as the second thermal treatment. T₃ can be set to be equal to or higher than 200°C and equal to or lower than 350°C, for example.

Then, the semiconductor element 20 and the substrate 30 are electrically connected to each other by using the bonding wire 40. Subsequently, the semiconductor element 20 is sealed with the sealing resin 50. In the present embodiment, the semiconductor device 100 can be manufactured in this way, for example.

In the present embodiment, a heatsink may be bonded to the semiconductor device, for example. In this case, for example, through an adhesive layer obtained by performing a thermal treatment on the thermally conductive composition, the heatsink can be bonded to the semiconductor device.

The heatsink can be bonded by the following method, for example. First, through the aforementioned thermally conductive composition, the heatsink is bonded to the semiconductor device. Then, a thermal treatment is performed on the thermally conductive composition. The thermal treatment for the thermally conductive composition can be performed in the same manner as in the step of forming the die-attach layer 10 by performing a thermal treatment on the thermally conductive composition in the aforementioned method for manufacturing the semiconductor device 100, for example. In a case where the thermal treatment is performed as above, sintering occurs in the metal particles (A) in the thermally conductive composition. As a result, a particle coupling structure is formed between the metal particles (A), and an adhesive layer to which the heatsink is bonded is formed. In this way, the heatsink can be bonded to the semiconductor device.

### Examples

All of the examples mentioned below are for reference only and do not fall under the scope of the invention.

### (Preparation of thermally conductive composition)

For each of examples and comparative examples, a thermally conductive composition was prepared. The compositions were prepared by homogeneously mixing each of the components together according to the formulation shown in Table 1. The details of the components shown in Table 1 are as below. The formulation ratio of each of the components in Table 1 represents a formulation ratio (% by mass) of each of the components with respect to the total amount of the thermally conductive composition.

Regarding the metal particles (A) used in each example, Table 1 shows "D₅₀", "Standard deviation", "D₉₅", "D₅", "Value obtained by dividing standard deviation of metal particles (A) by D₅₀ (standard deviation of metal particles (A) /D₅₀)", and "Difference between D₉₅ of metal particles (A) and D₅₀ of metal particles (A) (D₉₅ - D₅₀)" of the entirety of the metal particles (A).

The particle size of the metal particles (A) was determined by measuring particle images by using a flow-type particle image analyzer FPIA (registered trademark)-3000 manufactured by Sysmex Corporation, for example. More specifically, by measuring a volume-based median diameter by using the aforementioned device, the particle size of the metal particles (A) was determined.

### (Metal particles (A))

Metal particles 1: spherical silver powder (AG 2-1C, manufactured by DOWA Electronics Materials Co., Ltd)
Metal particles 2: flake-like silver powder (AgC-271B, manufactured by FUKUDA METAL FOIL & POWDER Co., LTD)
Metal particles 3: spherical silver powder (AGC-TC6, manufactured by FUKUDA METAL FOIL & POWDER Co., LTD)
Metal particles 4: flake-like silver powder (AgC-221A, manufactured by FUKUDA METAL FOIL & POWDER Co., LTD)
Metal particles 5: flake-like silver powder (AgC-GS, manufactured by FUKUDA METAL FOIL & POWDER Co., LTD)
Metal particles 6: flake-like silver powder (AgC-238, manufactured by FUKUDA METAL FOIL & POWDER Co., LTD)
Metal particles 7: flake-like silver powder (AgC-2612 manufactured by FUKUDA METAL FOIL & POWDER Co., LTD)
Metal particles 8: flake-like silver powder (AgC-2611, manufactured by FUKUDA METAL FOIL & POWDER Co., LTD)
Metal particles 9: flake-like silver powder (TGC-1, manufactured by TOKURIKI HONTEN CO., LTD.)

### (Dispersion medium (B))

Dispersion medium 1: 1,4-cyclohexanedimethanol monoacrylate (CHDMMA (trade name), manufactured by Nippon Kasei Chemical Co. , Ltd)
Dispersion medium 2: phenoxyethyl methacrylate (LIGHT ESTER PO, manufactured by KYOEISHA CHEMICAL Co., LTD)
Dispersion medium 3: ethylene glycol dimethacrylate (LIGHT ESTER EG, manufactured by KYOEISHA CHEMICAL Co., LTD)
Dispersion medium 4: meta·para-cresyl glycidyl ether (m,p-CGE (trade name), manufactured by Sakamoto Yakuhin kogyo Co., Ltd.)

### (Curing agent (C))

Curing agent 1: dicumyl peroxide (PERKADOX BC, manufactured by Kayaku Akzo Corporation)
Curing agent 2: imidazole (2PHZ-PW, manufactured by SHIKOKU CHEMICALS CORPORATION)

For each of the examples, a coating film obtained by performing coating by using the obtained thermally conductive composition was heated to 250°C from 25°C at a heating rate of 5°C/min in a nitrogen atmosphere with a residual oxygen concentration of lower than 1,000 ppm. Then, a thermal treatment was performed on the coating film under conditions of 250°C and 2 hours. As a result, the metal particles (A) in the coating film caused sintering and formed a particle coupling structure.

It was confirmed that a linear polymer molecular structure is obtained in the thermally conductive composition of each example.

### (Evaluation)

The thermally conductive composition obtained as above was evaluated according to the following items. The results are shown in Table 1.

### (Acetone insoluble fraction)

For each of the examples and comparative examples, an acetone insoluble fraction of the obtained thermally conductive composition was measured as below. First, by centrifugation and filtration using a 115 mesh filter (125 µm opening), the metal particles (A) were removed from the paste-like adhesive composition. Then, the thermally conductive composition from which the metal particles (A) had been removed was heated under conditions of 180°C and 2 hours, thereby obtaining a measurement sample. Thereafter, approximately 100 g of the measurement sample was weighed and put into an airtight container containing approximately 900 g of acetone with a liquid temperature of 25°C, and then shaken for about 20 minutes. The acetone solution obtained in this way and an acetone solution obtained by washing off the inside of the airtight container with approximately 100 g of acetone were passed through a 115 mesh (125 µm opening) JIS standard sieve. Consequently, approximately 100 g of acetone was passed through the entirety of the sieve. Then, the residue on the sieve was air-dried, and then the weight of the residue was measured. From the measured result, a ratio (% by mass) of the residue to the total amount of the measurement sample was calculated and taken as an acetone insoluble fraction (% by mass). In Table 1, "equal to or lower than 5" is listed for the composition in which the acetone insoluble fraction is equal to or lower than 5% by weight, and "higher than 5" is listed for the composition in which the acetone insoluble fraction is higher than 5% by weight.

### (Temperature at 5% weight loss)

In addition to the results shown in Table 1, for each of the examples and comparative examples, the temperature at 5% weight loss of the thermally conductive composition was measured. By performing thermogravimetry/differential thermal analysis (TG/DTA) on 10 mg of the thermally conductive composition under a condition of a heating rate of 5°C/min, the temperature at 5% weight loss was measured. The temperature at 5% weight loss was measured in a nitrogen atmosphere.

Regarding the temperature at 5% weight loss, a composition having a temperature at 5% weight loss of equal to or higher than 100°C and equal to or lower than 180°C was evaluated to be "O", and a composition of which a temperature at 5% weight loss did not fall into the above range was evaluated to be "X".

### (Temperature width W)

For each of the examples and comparative examples, the dynamic viscoelasticity of the obtained thermally conductive composition was measured. The dynamic viscoelasticity was measured using a rheometer (HAAKE RheoWin, manufactured by Thermo Fisher Scientific) under conditions of a measurement frequency of 1 Hz, a heating rate of 5°C/min, and a range of measurement temperature of 25°C to 250°C. From the measured results, a temperature width W (°C) in which a shear modulus of elasticity was equal to or higher than 5,000 Pa and equal to or lower than 100,000 Pa within a temperature region of 140°C to 180°C was calculated.

### (Thermal conductivity (thickness direction))

For each of the examples and comparative examples, the thermal conductivity was measured as below. First, coating was performed using the obtained thermally conductive composition, and then the coating film was heated to 250°C from 25°C at a heating rate of 5°C/min in a nitrogen atmosphere and then heated under conditions of 250°C and 2 hours, thereby obtaining a sample (film thickness: 1,000 µm). Thereafter, by a laser flash method, the thermal conductivity of the sample in a thickness direction was measured.

### (Volume resistivity (surface direction))

For each of the examples and comparative examples, the volume resistivity was measured as below. First, coating was performed using the obtained thermally conductive composition, and the coating film was heated to 250°C from 25°C at a heating rate of 5°C/min in a nitrogen atmosphere and then heated under conditions of 250°C and 2 hours, thereby obtaining a sample (width: 4 mm, length: 40 mm, thickness: 40 µm). Thereafter, the volume resistivity of the sample in a plane direction was measured according to JIS K 6911.

### (Dispensing properties)

For each of the examples and comparative examples, the dispensing properties were evaluated as below. First, a syringe was filled with the obtained thermally conductive composition, and a needle having an inner diameter of 200 µm as a nozzle diameter was mounted on the syringe. Then, by using an automatic dispenser, coating was performed by means of dispensing the paste in the form of a dot. Furthermore, the threading properties at the time of coating were visually observed. The composition that did not show the threading and the deformation of dots was marked with "A", the composition that showed either the threading or the deformation of dots was marked with "B", and the composition that showed both of the threading and the deformation of dots was marked with "C".

### (Evaluation of sintering uniformity)

For each of the examples and comparative examples, the cross-sectional structure of the die-attach layer of the semiconductor device 1 was observed. Herein, within the die-attach layer, the central portion and the peripheral portion in the surface direction were observed. The semiconductor device in which the sintering of the metal particles (A) sufficiently occurred in both of the central portion and the peripheral portion was marked with "o", and the semiconductor device in which the sintering of the metal particles (A) did not sufficiently occur in either the central portion or the peripheral portion was marked with "X". In this way, whether or not the sintering can be uniformly performed was evaluated.

### (Preparation of semiconductor device 1)

For each of the examples and comparative examples, a semiconductor device 1 was prepared as below. First, a 10 mm × 10 mm × 350 µmt rectangular silicon chip with a Au-plated rear surface was mounted on a Ag-plated copper frame (11 mm × 11 mm × 150 µmt) through the thermally conductive composition obtained as above, thereby obtaining a laminate. Then, in a nitrogen atmosphere with a residual oxygen concentration of lower than 1, 000 ppm, the laminate was heated to 250°C from 25°C at a heating rate of 5°C/min in an oven and then heated at 250°C for 2 hours. In this way, the metal particles (A) in the thermally conductive composition were sintered, and a die-attach layer having a thickness of 60 µm was formed. In this way, a semiconductor device 1 was obtained.

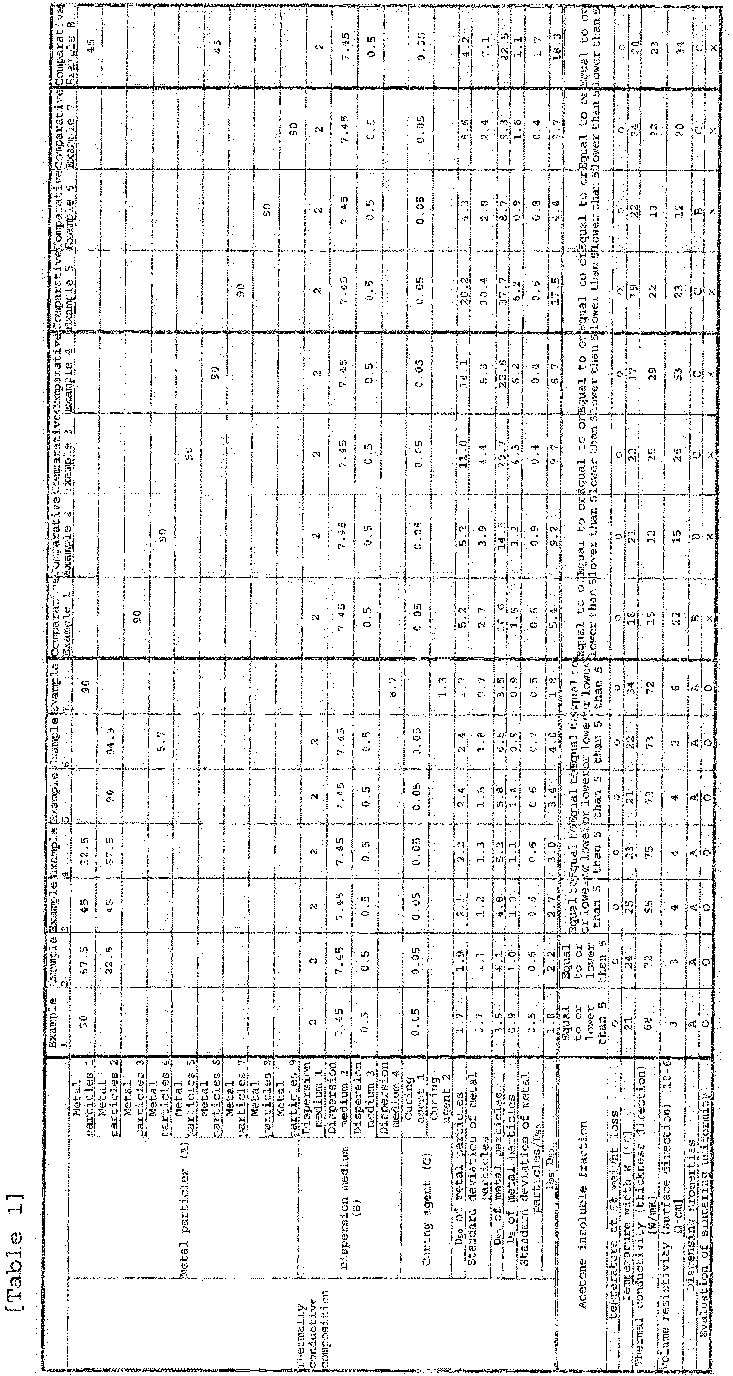

It is understood that in Examples 1 to 7, excellent results are obtained in all of the evaluation of sintering uniformity and the evaluation of dispensing properties. Furthermore, it is understood that in Examples 1 to 7, from the viewpoint of thermal conductivity and electric conductivity, excellent results are obtained compared to the comparative examples.

These results show that according to the present invention, it is possible to provide a thermally conductive composition having excellent sintering properties and high thermal conductivity.

The present application claims a priority based on Japanese Patent Application No. 2015-137152 filed on July 8, 2015.

## Claims

1. A thermally conductive composition comprising:
metal particles (A); and
a dispersion medium (B) in which the metal particles (A) are dispersed,
wherein the metal particles (A) form a particle coupling structure by being sintered through a thermal treatment performed on the thermally conductive composition,
the metal particles (A) have a particle size D₅₀ at 50% in a volume-based cumulative distribution of equal to or greater than 1 µm and equal to or smaller than 4 µm,
the metal particles (A) have a standard deviation of the particle size of equal to or less than 2.0 µm, where the particle size of the metal particle is determined by measuring a volume-based median diameter by using a flow-type particle image analyzer FPIA (registered trademark)-3000 manufactured by Sysmex Corporation, and
the dispersion medium (B) includes a compound having only one radically polymerizable double bond in a molecule and a compound having two or more epoxy groups in a molecule.

2. The thermally conductive composition according to claim 1,
wherein a value obtained by dividing the standard deviation of the particle size of the metal particles (A) by the particle size D₅₀ at 50% in a volume-based cumulative distribution of the metal particles (A) is equal to or less than 2.5.

3. The thermally conductive composition according to claim 1 or 2,
wherein the metal particles (A) have a particle size D₉₅ at 95% in a volume-based cumulative distribution of equal to or less than 10 µm.

4. The thermally conductive composition according to any one of claims 1 to 3,
wherein the metal particles (A) have a particle size D₅ at 5% in a volume-based cumulative distribution of equal to or greater than 0.6 µm.

5. The thermally conductive composition according to any one of claims 1 to 4,
wherein a difference between the particle size D₉₅ at 95% in a volume-based cumulative distribution of the metal particles (A) and the particle size D₅₀ at 50% in a volume-based cumulative distribution of the metal particles (A) is equal to or less than 5 µm.

6. The thermally conductive composition according to any one of claims 1 to 5,
wherein the metal particles (A) contain one or two or more metals selected from the group consisting of Ag, Au, and Cu.

7. The thermally conductive composition according to any one of claims 1 to 6,
wherein the metal particles (A) include spherical particles.

8. The thermally conductive composition according to any one of claims 1 to 7,
wherein the metal particles (A) include flake-like particles.

9. The thermally conductive composition according to any one of claims 1 to 8,
wherein the metal particles (A) include both of the spherical particles and the flake-like particles.

10. The thermally conductive composition according to any one of claims 1 to 9,
wherein a content of the metal particles (A) with respect to the total amount of the thermally conductive composition is equal to or greater than 80% by mass and equal to or smaller than 95% by mass.

11. The thermally conductive composition according to any one of claims 1 to 10,
wherein in a case where dynamic viscoelasticity is measured under a condition of a measurement frequency of 1 Hz, within a temperature range of 140°C to 180°C, the thermally conductive composition has a temperature width of equal to or larger than 10°C in which a shear modulus of elasticity is equal to or higher than 5,000 Pa and equal to or lower than 100,000 Pa.

12. The thermally conductive composition according to any one of claims 1 to 11,
wherein an acetone insoluble fraction of a sample, which is obtained by removing the metal particles (A) and then heating the composition under conditions of 180°C and 2 hours, is equal to or lower than 5% by mass.

13. The thermally conductive composition according to claim 1,
wherein the compound having only one radically polymerizable double bond in a molecule includes a compound represented by Formula (1), 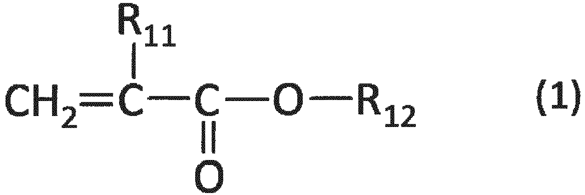 wherein in Formula (1), R₁₁ represents hydrogen or a methyl group, and R₁₂ represents a monovalent organic group having 1 to 20 carbon atoms.

14. The thermally conductive composition according to any one of claims 1 to 12,
wherein the dispersion medium (B) further includes a compound having only one epoxy group in a molecule.

15. The thermally conductive composition according to any one of claims 1 to 14,
wherein a temperature at 5% weight loss of the composition is equal to or higher than 100°C and equal to or lower than 180°C.

16. A semiconductor device comprising:
a substrate; and
a semiconductor element mounted on the substrate through an adhesive layer obtained by performing thermal treatment on the thermally conductive composition according to any one of claims 1 to 15.

17. The semiconductor device according to claim 16,
wherein a planar shape of the semiconductor element is a rectangle having a side equal to or longer than 5 mm.

18. A method for manufacturing a semiconductor device, comprising:
a step of mounting a semiconductor element on a substrate through the thermally conductive composition according to any one of claims 1 to 15; and
a step of heating the thermally conductive composition.

19. The method for manufacturing a semiconductor device according to claim 18,
wherein the step of heating the thermally conductive composition comprises a step of heating the thermally conductive composition under a temperature condition of lower than 200°C and a step of heating the thermally conductive composition under a temperature condition of equal to or higher than 200°C.

20. The method for manufacturing a semiconductor device according to claim 18 or 19,
wherein the step of heating the thermally conductive composition is performed in a state of applying a pressure to the thermally conductive composition.

21. A method for bonding a heatsink, comprising:
a step of bonding a heatsink to a semiconductor device through the thermally conductive composition according to any one of claims 1 to 15; and
a step of heating the thermally conductive composition.

22. The method for bonding a heatsink according to claim 21,
wherein the step of heating the thermally conductive composition comprises a step of heating the thermally conductive composition under a temperature condition of lower than 200°C and a step of heating the thermally conductive composition under a temperature condition of equal to or higher than 200°C.

23. The method for bonding a heatsink according to claim 21 or 22,
wherein the step of heating the thermally conductive composition is performed in a state of applying a pressure to the thermally conductive composition.

## Patentansprüche

1. Wärmeleitende Zusammensetzung, umfassend:
Metallteilchen (A); und
ein Dispersionsmedium (B), in dem die Metallteilchen (A) dispergiert sind,
wobei die Metallteilchen (A) eine Teilchenverbindungsstruktur bilden, indem sie durch eine Wärmebehandlung, die an der wärmeleitenden Zusammensetzung durchgeführt wird, gesintert werden,
die Metallteilchen (A) eine Teilchengröße D₅₀ bei 50% in einer volumenbasierten kumulativen Verteilung von gleich oder größer als 1 µm und gleich oder kleiner als 4 µm aufweisen,
die Metallteilchen (A) eine Standardabweichung der Teilchengröße von gleich oder weniger als 2,0 µm aufweisen, wobei die Teilchengröße der Metallteilchen durch Messen eines volumenbasierten mittleren Durchmessers unter Verwendung eines von der Sysmex Corporation hergestellten Teilchenbildanalysators vom Durchflusstyp FPIA (eingetragenes Warenzeichen)-3000 bestimmt wird, und
das Dispersionsmedium (B) eine Verbindung mit nur einer radikalisch polymerisierbaren Doppelbindung in einem Molekül und eine Verbindung mit zwei oder mehr Epoxygruppen in einem Molekül enthält.

2. Wärmeleitende Zusammensetzung nach Anspruch 1,
wobei ein Wert, der durch Teilen der Standardabweichung der Teilchengröße der Metallteilchen (A) durch die Teilchengröße D₅₀ bei 50 % in einer volumenbasierten kumulativen Verteilung der Metallteilchen (A) erhalten wird, gleich oder kleiner als 2,5 ist.

3. Wärmeleitende Zusammensetzung nach Anspruch 1 oder 2,
wobei die Metallteilchen (A) eine Teilchengröße D₉₅ bei 95% in einer volumenbasierten kumulativen Verteilung von gleich oder kleiner als 10 µm aufweisen.

4. Wärmeleitende Zusammensetzung nach einem der Ansprüche 1 bis 3,
wobei die Metallteilchen (A) eine Teilchengröße D₅ bei 5% in einer volumenbasierten kumulativen Verteilung von gleich oder größer als 0,6 µm aufweisen.

5. Wärmeleitende Zusammensetzung nach einem der Ansprüche 1 bis 4,
wobei eine Differenz zwischen der Teilchengröße D₉₅ bei 95% in einer volumenbasierten kumulativen Verteilung der Metallteilchen (A) und der Teilchengröße D₅₀ bei 50% in einer volumenbasierten kumulativen Verteilung der Metallteilchen (A) gleich oder kleiner als 5 µm ist.

6. Wärmeleitende Zusammensetzung nach einem der Ansprüche 1 bis 5,
wobei die Metallteilchen (A) ein oder zwei oder mehr Metalle enthalten, die aus der Gruppe ausgewählt sind, die aus Ag, Au und Cu besteht.

7. Wärmeleitende Zusammensetzung nach einem der Ansprüche 1 bis 6,
wobei die Metallteilchen (A) kugelförmige Teilchen enthalten.

8. Wärmeleitende Zusammensetzung nach einem der Ansprüche 1 bis 7,
wobei die Metallteilchen (A) flockenartige Teilchen enthalten.

9. Wärmeleitende Zusammensetzung nach einem der Ansprüche 1 bis 8,
wobei die Metallteilchen (A) sowohl die kugelförmigen Teilchen als auch die flockenartigen Teilchen enthalten.

10. Wärmeleitende Zusammensetzung nach einem der Ansprüche 1 bis 9,
wobei der Gehalt der Metallteilchen (A) in Bezug auf die Gesamtmenge der wärmeleitenden Zusammensetzung gleich oder größer als 80 Massenprozent und gleich oder kleiner als 95 Massenprozent ist.

11. Wärmeleitende Zusammensetzung nach einem der Ansprüche 1 bis 10,
wobei in einem Fall, in dem die dynamische Viskoelastizität unter einer Bedingung einer Messfrequenz von 1 Hz innerhalb eines Temperaturbereichs von 140°C bis 180°C gemessen wird, die wärmeleitende Zusammensetzung eine Temperaturbreite von gleich oder größer als 10°C aufweist, in der ein Scherelastizitätsmodul gleich oder höher als 5000 Pa und gleich oder niedriger als 100000 Pa ist.

12. Wärmeleitende Zusammensetzung nach einem der Ansprüche 1 bis 11,
wobei eine acetonunlösliche Fraktion einer Probe, die durch Entfernen der Metallteilchen (A) und anschließendes Erhitzen der Zusammensetzung unter Bedingungen von 180°C und 2 Stunden erhalten wird, gleich oder weniger als 5 Massenprozent beträgt.

13. Wärmeleitende Zusammensetzung nach Anspruch 1,
wobei die Verbindung mit nur einer radikalisch polymerisierbaren Doppelbindung in einem Molekül eine Verbindung der Formel (1) einschließt, 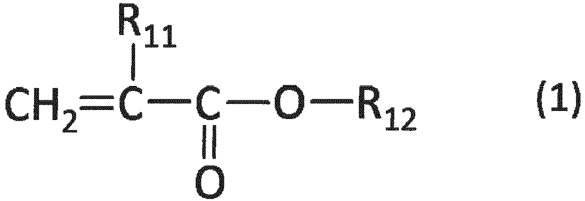 wobei in Formel (1) R₁₁ Wasserstoff oder eine Methylgruppe darstellt und R₁₂ eine einwertige organische Gruppe mit 1 bis 20 Kohlenstoffatomen darstellt.

14. Wärmeleitende Zusammensetzung nach einem der Ansprüche 1 bis 12,
wobei das Dispersionsmedium (B) weiter eine Verbindung mit nur einer Epoxygruppe in einem Molekül enthält.

15. Wärmeleitende Zusammensetzung nach einem der Ansprüche 1 bis 14,
wobei eine Temperatur bei 5 % Gewichtsverlust der Zusammensetzung gleich oder höher als 100 °C und gleich oder niedriger als 180 °C ist.

16. Halbleiterbauelement, umfassend:
ein Substrat; und
ein Halbleiterelement, das auf dem Substrat durch eine Haftmittelschicht befestigt ist, die durch thermische Behandlung der wärmeleitenden Zusammensetzung nach einem der Ansprüche 1 bis 15 erhalten wurde.

17. Halbleiterbauelement nach Anspruch 16,
wobei eine planare Form des Halbleiterelements ein Rechteck mit einer Seite gleich oder länger als 5 mm ist.

18. Verfahren zur Herstellung eines Halbleiterbauelements, umfassend:
einen Schritt des Befestigens eines Halbleiterelements auf einem Substrat durch die wärmeleitende Zusammensetzung nach einem der Ansprüche 1 bis 15; und
einen Schritt des Erwärmens der wärmeleitenden Zusammensetzung.

19. Verfahren zur Herstellung eines Halbleiterbauelements nach Anspruch 18, wobei der Schritt des Erwärmens der wärmeleitenden Zusammensetzung einen Schritt des Erwärmens der wärmeleitenden Zusammensetzung unter einer Temperaturbedingung von weniger als 200°C und einen Schritt des Erwärmens der wärmeleitenden Zusammensetzung unter einer Temperaturbedingung von gleich oder höher als 200°C umfasst.

20. Verfahren zur Herstellung eines Halbleiterbauelements nach Anspruch 18 oder 19,
wobei der Schritt des Erwärmens der wärmeleitenden Zusammensetzung in einem Zustand durchgeführt wird, in dem ein Druck auf die wärmeleitende Zusammensetzung ausgeübt wird.

21. Verfahren zum Bonden eines Kühlkörpers, umfassend:
einen Schritt des Bondens eines Kühlkörpers mit einem Halbleiterbauelement durch die wärmeleitende Zusammensetzung nach einem der Ansprüche 1 bis 15; und
einen Schritt des Erwärmens der wärmeleitenden Zusammensetzung.

22. Verfahren zum Bonden eines Kühlkörpers nach Anspruch 21,
wobei der Schritt des Erwärmens der wärmeleitenden Zusammensetzung einen Schritt des Erwärmens der wärmeleitenden Zusammensetzung unter einer Temperaturbedingung von weniger als 200°C und einen Schritt des Erwärmens der wärmeleitenden Zusammensetzung unter einer Temperaturbedingung von gleich oder höher als 200°C umfasst.

23. Verfahren zum Bonden eines Kühlkörpers nach Anspruch 21 oder 22,
wobei der Schritt des Erwärmens der wärmeleitenden Zusammensetzung in einem Zustand durchgeführt wird, in dem ein Druck auf die wärmeleitende Zusammensetzung ausgeübt wird.

## Revendications

1. Composition thermiquement conductrice, comprenant :
des particules métalliques (A), et
un milieu de dispersion (B), dans lequel les particules métalliques (A) sont dispersées,
dans lequel les particules métalliques (A) forment une structure particulaire de couplage par frittage au moyen d'un traitement thermique réalisé sur la composition thermiquement conductrice,
les particules métalliques (A) ayant une taille particulaire D₅₀ à 50% dans une distribution cumulée sur base volumique, égale ou supérieure à 1 µm et égal ou inférieur à 4 µm,
les particules métalliques (A) ayant un écart type de la taille particulaire égal ou inférieur à 2,0 µm, la taille particulaire des particules métallique étant déterminée par mesure du diamètre médian sur base volumique en utilisant un analyseur d'image de particules de type écoulement FPIA (marque déposée)-3000, fabriqué par Sysmex Corporation, et
le milieu de dispersion (B) comprend un composé n'ayant qu'une double liaison polymérisable de manière radicalaire par molécule et un composé ayant deux groupes époxy ou plus par molécule.

2. Composition thermiquement conductrice selon la revendication 1, dans laquelle la valeur obtenue en divisant l'écart type de la taille particulaire des particules métalliques (A) par la taille particulaire D₅₀ à 50% dans une distribution cumulée sur base volumique des particules métalliques (A) est égale ou inférieure à 2,5.

3. Composition thermiquement conductrice selon la revendication 1 ou 2, dans laquelle les particules métalliques (A) ont une taille particulaire D₉₅ à 95% dans une distribution cumulée sur base volumique égale ou inférieure à 10 µm.

4. Composition thermiquement conductrice selon l'une quelconque des revendications 1 à 3, dans laquelle les particules métalliques (A) ont une taille particulaire D₅ à 5% dans une distribution cumulée sur base volumique égale ou supérieure à 0,6 µm.

5. Composition thermiquement conductrice selon l'une quelconque des revendications 1 à 4, dans laquelle la différence entre la taille particulaire D₉₅ à 95% dans une distribution cumulée sur base volumique des particules métalliques (A) et la taille particulaire D₅₀ à 50% dans une distribution cumulée sur base volumique des particules métalliques (A) est égale ou inférieure à 5 µm.

6. Composition thermiquement conductrice selon l'une quelconque des revendications 1 à 5, dans laquelle les particules métalliques (A) contiennent un, deux métaux ou plus, choisis parmi le groupe consistant en Ag, Au et Cu.

7. Composition thermiquement conductrice selon l'une quelconque des revendications 1 à 6, dans laquelle les particules métalliques (A) comprennent des particules sphériques.

8. Composition thermiquement conductrice selon l'une quelconque des revendications 1 à 7, dans laquelle les particules métalliques (A) comprennent des particules de type paillette.

9. Composition thermiquement conductrice selon l'une quelconque des revendications 1 à 8, dans laquelle les particules métalliques (A) comprennent tant des particules sphériques que des particules de type paillette.

10. Composition thermiquement conductrice selon l'une quelconque des revendications 1 à 9, dans laquelle la teneur en particules métalliques (A) par rapport à la quantité totale de la composition thermiquement conductrice est égale ou supérieure à 80% en masse et égale ou inférieure à 95% en masse.

11. Composition thermiquement conductrice selon l'une quelconque des revendications 1 à 10, dans laquelle dans le cas où la viscoélasticité dynamique est mesurée dans des conditions de fréquence de mesure de 1 Hz, au sein de la plage de température allant de 140°C à 180°C, la composition thermiquement conductrice présente une largeur de température égale ou supérieure à 10°C, où le module de cisaillement de l'élasticité est égal ou supérieur à 5000 Pa et égal ou inférieur à 100 000 Pa.

12. Composition thermiquement conductrice selon l'une quelconque des revendications 1 à 11, dans laquelle une fraction insoluble dans l'acétone d'un échantillon, qui est obtenu par élimination des particules métalliques (A), puis chauffage de la composition dans les conditions de 180°C et 2 heures, est égale ou inférieure à 5% en masse.

13. Composition thermiquement conductrice selon la revendication 1, dans laquelle le composé n'ayant qu'une double liaison polymérisable de manière radicalaire par molécule comprend un composé représenté par la formule (1), 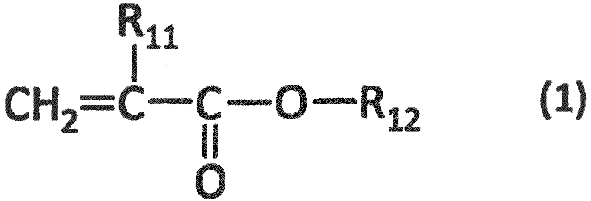 où dans la formule (1), R₁₁ représente hydrogène ou un groupe méthyle, et R₁₂ représente un groupe organique monovalent ayant 1 à 20 atomes de carbone.

14. Composition thermiquement conductrice selon l'une quelconque des revendications 1 à 12, dans laquelle le milieu de dispersion (B) comprend en outre, un composé ayant seulement un groupe époxy par molécule.

15. Composition thermiquement conductrice selon l'une quelconque des revendications 1 à 14, dans laquelle la température à une perte de poids de 5% de la composition est égale ou supérieure à 100°C et égale ou inférieure à 180°C.

16. Dispositif semiconducteur, comprenant :
un substrat, et
un élément semiconducteur monté sur le substrat au moyen d'une couche adhésive obtenue par application d'un traitement thermique sur la composition thermiquement conductrice selon l'une quelconque des revendications 1 à 15.

17. Dispositif semiconducteur selon la revendication 16, dans lequel une forme plane de l'élément semiconducteur est un rectangle dont un côté présente une dimension égale ou supérieure à 5 mm.

18. Procédé de production d'un dispositif semiconducteur, comprenant :
une étape de montage d'un élément semiconducteur sur un substrat au moyen de la composition thermiquement conductrice selon l'une quelconque des revendications 1 à 15, et
une étape de chauffage de la composition thermiquement conductrice.

19. Procédé de production d'un dispositif semiconducteur selon la revendication 18, dans lequel l'étape de chauffage de la composition thermiquement conductrice comprend une étape de chauffage de la composition thermiquement conductrice dans des conditions de température de moins de 200°C et une étape de chauffage de la composition thermiquement conductrice dans des conditions de température égales ou supérieures à 200°C.

20. Procédé de production d'un dispositif semiconducteur selon la revendication 18 ou 19, dans lequel l'étape de chauffage de la composition thermiquement conductrice est réalisée avec application d'une pression sur la composition thermiquement conductrice.

21. Procédé de liaison d'un dissipateur thermique, comprenant :
une étape de liaison d'un dissipateur thermique à un dispositif semiconducteur au moyen de la composition thermiquement conductrice selon l'une quelconque des revendications 1 à 15, et
une étape de chauffage de la composition thermiquement conductrice.

22. Procédé de liaison d'un dissipateur thermique selon la revendication 21, dans lequel l'étape de chauffage de la composition thermiquement conductrice comprend une étape de chauffage de la composition thermiquement conductrice dans des conditions de température inférieures à 200°C et une étape de chauffage de la composition thermiquement conductrice dans des conditions de température égales ou supérieures à 200°C.

23. Procédé de liaison d'un dissipateur thermique selon la revendication 21 ou 22, dans lequel l'étape de chauffage de la composition thermiquement conductrice est réalisée avec application d'une pression sur la composition thermiquement conductrice.
